(19)

Europäisches
Patentamt
European
Patent Office
Office européen
des brevets

(11) **EP 1 894 662 A2**

(12) **EUROPEAN PATENT APPLICATION**

(43) Date of publication:
**05.03.2008 Bulletin 2008/10**

(51) Int Cl.:
**B23K 26/00** (2006.01)

(21) Application number: **07016006.4**

(22) Date of filing: **14.08.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK YU**

(30) Priority: **29.08.2006 JP 2006232733**

(71) Applicant: **Nitto Denko Corporation
Ibaraki-shi,
Osaka 567-8680 (JP)**

(72) Inventors:
• **Sasaki, Takatoshi
Ibaraki-shi
Osaka 567-8680 (JP)**
• **Miki, Tsubasa
Ibaraki-shi
Osaka 567-8680 (JP)**

• **Asai, Fumiteru
Ibaraki-shi
Osaka 567-8680 (JP)**
• **Takahashi, Tomokazu
Ibaraki-shi
Osaka 567-8680 (JP)**
• **Shintani, Toshio
Ibaraki-shi
Osaka 567-8680 (JP)**
• **Yamamoto, Akiyoshi
Ibaraki-shi
Osaka 567-8680 (JP)**

(74) Representative: **Hager, Thomas Johannes
Hoefer & Partner
Patentanwälte
Pilgersheimer Strasse 20
81543 München (DE)**

(54) **Adhesive sheet for water jet laser dicing**

(57)   An adhesive sheet for water jet laser dicing, comprises an adhesive layer laminated on a base film, wherein the adhesive constituting the adhesive layer is an energy radiation curing type adhesive, and said adhesive sheet has an adhesive strength of at least 1.5 N/ 20 mm.

EP 1 894 662 A2

**Description**

BACKGROUND OF THE INVENTION

1. Field of the Invention

The present invention relates to an adhesive sheet for water jet laser dicing, and more particularly relates to an adhesive sheet for water jet laser dicing used to fix a semiconductor wafer and/or a semiconductor-related material during dicing with a water jet laser.

2. Background Information

The conventional practice has been to use a rotary blade known as a dicing blade to cut semiconductor wafers, semiconductor-related materials and the like, and separate them into chips and IC parts. In this dicing step, the semiconductor wafer or the like is usually first affixed with an adhesive tape called a dicing tape, for example, to fix it in place. After the semiconductor wafer or the like has been cut into chips, they are removed from the adhesive tape by a pick-up.
However, physical stress produced by the dicing blade can cause die fly-off in the chips and the like cut by this method, or cause cracking, chipping, and other such defects, which lowers the quality of the chips and the like, and also lowers the efficiency of this cutting method. Consequently, there have been attempts at increasing the adhesive strength of adhesive tape, but this problem has become more serious as there has been greater demand for even smaller and thinner electronic devices in recent years.
Meanwhile, increasing the adhesive strength of an adhesive tape makes it more difficult to remove the chips or the like after dicing, and in some cases can even lead to chipping or other defects in the chips or the like. Also, contaminants to the wafer or the like stick more tightly to the adhesive tape, and can foul the dicing apparatus.
In view of this, a dicing method that makes use of a laser beam, and particularly a method for processing materials by cutting, perforating, welding, stamping, peeling, or the like using a laser beam guided by a liquid jet, has been proposed as an alternative to techniques for cutting semiconductor wafers and the like with a dicing blade (see WO95/32834, for example). With this method, the wafer or the like is merely exposed to a water jet from above, which prevents die fly-off and the like caused by the physical stress produced by a rotating blade.
Also, with a cutting method that makes use of this laser technique, the use of a water jet can be a problem in that it makes the chips or the like more susceptible to coming loose from the adhesive tape that fixes them, and in an effort to deal with this, an adhesive tape has been proposed that can be used preferably in water jet laser dicing (see Japanese Laid-Open Patent Application 2001-316648, for example).

SUMMARY OF THE INVENTION

There is an urgent need for a way to process semiconductor wafers and/or semiconductor-related materials, which are being made thinner, by water jet laser dicing into smaller and thinner chips, IC parts, or the like. Also, along with changes in dicing technology, the critical significance of the adhesive strength of an adhesive sheet used for dicing is also changing. In light of this situation, it is an object of the present invention to provide an adhesive sheet with which good adhesion to wafers and the like during dicing is ensured, the chips or parts are prevented from separating from the adhesive tape, and extremely thin semiconductor wafers or materials can be processed without causing chipping or other such defects in the removal of the chips, IC parts, or the like after dicing.
The present invention provides an adhesive sheet for water jet laser dicing, comprising an adhesive layer laminated on a base film,
wherein the adhesive constituting the adhesive layer is an energy radiation curing type adhesive, and said adhesive sheet has an adhesive strength of at least 1.5 N/20 mm.
According to the present invention, it is possible to provide an adhesive sheet with which good adhesion to wafers and the like during dicing is ensured, the chips or parts can be prevented from separating from the adhesive tape, and extremely thin semiconductor wafers or materials can be processed without causing chipping or other such defects in the removal of the chips, IC parts, or the like after dicing under an urgent need for a way to process semiconductor wafers and/or semiconductor-related materials, which are being made thinner, by water jet laser dicing into smaller and thinner chips, IC parts, or the like, along with changes in dicing technology, the critical significance of the adhesive strength of an adhesive sheet used for dicing is also changing.
The adhesive sheet for water jet laser dicing of the present invention can be utilized in a wide range of applications in which a material is diced with a laser beam guided by a liquid jet, that is, it can be applied not only to semiconductor-related materials and the like (such as semiconductor wafers, BGA packages, printed wiring boards, ceramic boards, glass member for liquid crystal devices, sheet materials, circuit boards, glass substrates, ceramics substrates, metal substrates light-emitting and light-receiving element substrates for semiconductor laser, MEMES substrates, semiconductor packages), but to all kinds of materials.

DETAILED DESCRIPTION OF THE PREFERRED EMBODIMENTS

The adhesive sheet for water jet laser dicing of the present invention mainly comprises a base film and an adhesive layer disposed on this base film. The phrase "adhesive sheet for water jet laser dicing" here refers to an adhesive sheet that is used in dicing with a laser beam guided by a liquid jet (usually a water jet), and with which the liquid used in this liquid jet during dicing, such as a liquid jet with at least a specific pressure, and the liquid that is applied directly or indirectly from the adhesive layer side can escape from one side of the adhesive sheet to the other side. The specific pressure here is usually about a few MPa or higher.

The adhesive layer comprises an adhesive coated on one side of the base film. This adhesive is preferably a type that is cured by an energy radiation, because this allows the layer to be easily removed from the workpiece. The energy radiation used here can be radiation of various wavelengths, such as ultraviolet rays, visible light rays, or infrared rays, but since the laser beam used for dicing is one with an oscillation wavelength less than 400 nm, such as a third or fourth harmonic of a YAG laser with an oscillation wavelength of 355 nm or 266 nm, XeCI excimer laser with an oscillation wavelength of 308 nm, or KrF excimer laser with an oscillation wavelength of 248 nm, or one with an oscillation wavelength greater than 400 nm, such as a titanium sapphire laser with a wavelength near 750 to 800 nm, which allows light absorption in the UV band via a multi-photon absorption process, which allows cutting at a width of 20 $\mu$m or less by multi-photon absorption ablation, and which has a pulse width of 1 e$^{-9}$ second or less, it is preferable to use an adhesive that will not be cured by a irradiation with the laser beam of the dicing apparatus being used.

A known adhesive including (meth)acrylic polymers and rubber-based polymers can be used as the material that forms the adhesive layer, but a (meth)acrylic polymer is particularly preferable because even when a photosensitive adhesive is formed, it can be cured without adding any special monomer/oligomer component or the like for an energy radiation curing.
Examples of rubber-based polymers include natural rubbers such as polyisoprene; and synthetic rubbers such as styrene-butadiene rubber or a rubber based on polybutadiene, butadiene-acrylonitrile, chloroprene and the like.

Examples of a monomer component of (meth)acrylic polymers include alkyl acrylates and alkyl methacrylates having linear or branched alkyl groups with 30 or fewer carbons, and preferably 4 to 18 carbons, such as methyl, ethyl, n-propyl, isopropyl, n-butyl, t-butyl, isobutyl, pentyl, isopentyl, hexyl, cyclohexyl, heptyl, 2-ethylhexyl, octyl, isooctyl, nonyl, isononyl, decyl, isodecyl, undecyl, rauryl, tridecyl, tetradecyl, stearyl, octadecyl, and dodecyl. These alkyl (meth) acrylates can be used alone or as mixture of more than two components.

Examples of a monomer component other than the above monomers include carboxyl-containing monomer such as acrylic acid, methacrylic acid, carboxyethyl (meth)acrylate, carboxypentyl (meth)acrylate, itaconic acid, maleic acid, fumaric acid, and crotonic acid; acid anhydride monomer such as maleic anhydride, itaconic anhydride; hydroxyl group-containing monomer such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydodecyl (meth)acrylate, 12-hydroxyrauryl (meth)acrylate, 4-hydroxymethyl cyclohexyl methyl(meth)acrylate; sulfonate-containing monomer such as styrenesulfonate, allylsulfonate, 2-(meth) acrylamide-2-methyl propanesulfonate, (meth)acrylamide propanesulfonate, sulfopropyl (meth)acrylate, (meth)acryloyl oxynaphthalenesulfonate; phosphate-containing monomer such as 2-hydroxyethyl acryloylphosphate; (meth)acrylamide; N-hydroxymethylamide (meth)acrylate; alkylamino alkylester(meth) acrylate such as dimethylamino ethylmethacrylate, t-butylamino ethylmethacrylate; N-vinylpyrrolidone; acryloyl morpholine; vinyl acetate; styrene; acrylonitrile and the like. These monomer components can be used alone or as mixture of more than two components.

Multifunctional monomers may be added as needed for the purpose of crosslinking (meth)acrylic polymer. Examples of the multifunctional monomer include hexanediol di(meth)acrylate, polyethylene glycol di(meth)acrylate, polypropylene glycol di(meth)acrylate, neopentylglycol di(meth)acrylate, pentaerythritol di(meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, epoxy(meth)acrylate, polyester (meth)acrylate, urethane (meth)acrylate and the like. These multifunctional monomer components can be used alone or as mixture of more than two components. From the standpoint of adhesion characteristic and the like, the amount in which the multifunctional monomers are contained is preferably no more than 30 wt%, more preferably no more than 20 wt% of the total monomer component.

It is even more preferable to use a monomer and/or oligomer having an energy radiation curable functional group, such as a carbon-carbon double bond.
Examples of the monomer and/or oligomer include urethane (meth)acrylate, trimethylolpropane tri(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, 1,4-butylene glycol di(meth)acrylate and the like. These components can be used alone or as mixture of more than two components. There are no particular restrictions on the amount in which these are contained, but from the standpoint of adhesion characteristic, about 5 to 500 weight parts, or about 70 to 150 weight parts per 100 weight parts of the (meth)acrylic polymer or other base polymer of the adhesive is preferable.

It is preferable to use a photopolymerization initiator when a photosensitive adhesive is formed. Examples of the photopolymerization initiator include acetophenone compounds such as 4-(2-hydroxyethoxy) phenyl(2-hydroxy-2-propyl) ketone, a-hydroxy-a,a-methyl acetophenone, methoxy acetophenone, 2.2-dimethoxy-2-phenyl acetophenone, 2,2-diethoxy-acetophenone, 1-hydroxycyclohexyl phenyl ketone, 2-methyl-1-[4-(methyltio)phenyl]-2-morpholinoprophane-1; benzoine ether compounds such as benzoine ethyl ether, benzoine isopropyl ether, anisoin methyl ether; a-ketol compounds such as 2-methyl-2-hydroxypropylphenon; ketal compounds such as benzyl dimethyl keral; aromatic sulfonyl chloride compounds such as 2-naphthalene sulfonyl chloride; light-active oxime compounds such as 1-phenon-1,1-propanedione-2-(o-ethoxycarbonyl) oxime; benzophenone compounds such as benzophenone, benzoylbenzoate, 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, 2,4-diisopropylthioxanthone; camphor chinone; ketone halide; acyl phosphinoxide; acyl phosphonate and the like. These components can be used alone or as mixture of more than two components. The amount in which the photopolymerization initiators are contained, about 0.1 to 10 weight parts, or about 0.5 to 5 weight parts per 100 weight parts of the base polymer of the adhesive is preferable.

A crosslinking agent may also be added to raise the weight average molecular weight of the base polymer. Examples of the crosslinking agent include polyisocyanate compounds, epoxy compounds, aziridine compounds, melamine resins, urea resins, anhydrous compounds, polyamines, carboxyl group-containing polymers and the like. These can be used alone or as mixture of more than two compounds. When a crosslinking agent is used, it is generally preferable for it to be used in an amount of about 0.01 to 5 weight parts per 100 weight parts base polymer so that the peeling-off adhesion strength will not decrease too much.
In addition to the above components, the adhesive may optionally comprise any conventional additive such as tackifiers, antioxidants, fillers, pigments and the like.

The acrylic polymer can be prepared, for example, by applying a known method such as solution polymerization, emulsion polymerization, mass polymerization, suspension polymerization to one or more kinds of monomer or a mixture thereof. Among these, solution polymerization is preferable. Examples of solvents that can be used include ethyl acetate, toluene and other such polar solvents. The solution concentration is usually about 20 to 80 wt%.

A polymerization initiator may be used in the preparation of the polymer. Examples of the polymerization initiator include peroxides such as hydrogen peroxide, benzoyl peroxide, t-butyl peroxide, and the like. One may be used by itself, or it may be combined with a reducing agent and used as a redox type of polymerization initiator. Examples of the reducing agent include ionic salts such as salts of iron, copper, cobalt sulfite, bisulfite; amines such as triethanol amine; reducing sugar such as aldose, ketose and the like. Also, azo compounds such as 2.2'-azobis-2-methylpropioamidine salt, 2,2'-azobis-2,4-dimethylvaleronitrile, 2,2'-azobis-N,N'-dimethyleneisobutylamidine salt, 2,2'-azobisisobutyronitrile, 2,2'-azobis-2-methyl-N-(2-hydroxyethyl) propionamide may be used. These can be used alone or as mixture of more than two components.

The reaction temperature is usually about 50 to 85°C, and the reaction time about 1 to 8 hours.
From the standpoint of preventing fouling of the workpiece and the like, it is preferable for the acrylic polymer to have a low content of low-molecular weight substances, and for the acrylic polymer to have a number average molecular weight of at least 300000, particularly at a range of about 800000 to 3000000.

The thickness of the adhesive layer can be suitably adjusted within a range in which the layer will not come off the workpiece, but from the standpoints of ensuring adequate adhesive strength, preventing undesirable adhesive residue from remaining on the back of the semiconductor wafer or the like after the wafer or the like has been removed from the tape, and allowing water to pass through easily by cutting the adhesive layer, the thickness is usually about 5 to 300 $\mu$m, preferably about 10 to 100 $\mu$m, more preferably about 20 to 50 $\mu$m.

As discussed below, the adhesive layer may include perforations just as the base film does. These perforations can be formed by any of the methods discussed below for the base film. The perforations may be formed at the same time as the perforations in the base film, or may be formed in a separate step.

Examples of the base film include non-woven, woven and the like made of a synthetic resin film, for example, polyolefins such as polyethylene, polypropylene (e.g., low-density polyethylene, liner low-density polyethylene, high-density polyethylene, drawn polypropylene, non-drawn polypropylene, ethylene-polypropylene copolymer, ethylene-vinyl acetate copolymer, ethylene-(meth)acrylic acid copolymer, ethylene-(meth)acrylic ester copolymer and the like), polyethylene terephthalate, polyurethane, EVA, polytetrafluoroethylene, polyvinyl chloride, polyvinylidene chloride, polyamide, acetal resin, polystyrene, polycarbonate, fluorocarbon polymer; rubber-containing polymer such as styrene-butadiene copolymer; polymer fiber such as PP, PVC, PE, PU, PS, PO, PET and the like; synthetic fiber such as rayon, acetylcellulose and the like; natural fiber such as cotton, silk, wool and the like; inorganic fiber such as glass fiber, carbon fiber and the like. These can be used single layer or multilayer of more than two layers. Among these, a layer made of or comprising polyolefins is preferable.

The base film possesses perforations which are perforated in the thickness direction of the base film or which is connected plural perforations. The perforations may be regularly or irregularly provided on the base film. When the material of the base film comprises fibers, the perforations may be obtained naturally as a result of the fiber-fiber interstices, thus, rendering the base film porous, and the base film may also contain artificial perforations. When the base film comprises polymeric resins, the perforations may be artificially introduced.

The base film can be perforated by conventional methods of making through-holes. Examples of such methods include mechanical, chemical and/or thermal methods generally known in the art. As mechanical methods of perforating the base film, punching by using a press machine or a rotary roll, laser treatment and water jet treatment may be mentioned. Moreover, inorganic particles can be formulated into the base film upon production of the base film. As a result, when the film is expanded, some of the particles are broken resulting in perforations in the base film. As chemical methods of perforating, the method wherein a blowing agent can be formulated into the base film material and upon production of the base film, blowing occurs resulting in the perforations in the base film may be mentioned. In another chemical method, a base polymer and a compound which is easily soluble in a solvent are used to prepare the base film. After the film sheeting the base film is then dipped into the solvent followed by drying and expansion, resulting in perforations.

The shape of the perforations is not limited as long as it ensures water-permeability, for example, the shape may be irregular as in the case of the fiber-fiber interstices, and circular, square, triangular, rhombic, star-like or other shape. The size of the perforations as measured by microscope is usually 3.0 mm$^2$ or less, 25 $\mu$m$^2$ to 3.0 mm$^2$, preferably 0.001 to 3.0 mm$^2$, more preferably 0.1 to 2.0 mm$^2$, most preferably 0.2 to 1.1 mm$^2$. If the perforations are circular in shape, the perforation size may preferably be 5 $\mu$m to 0.80 mm, 0.17 to 0.80 mm, more preferably 0.25 to 0.59 mm in diameter. If the perforations are square, triangular or rhombic shape, the perforation size may preferably be 5 $\mu$m to 1.40 mm, 0.30 to 1.40 mm, more preferably 0.45 to 1.00 mm in length on a side. The perforation density is preferably more than 100000 holes/m$^2$, more preferably 300000 to 700000 holes/m$^2$. The perforation density is calculated from the pitch distance in length direction and transverse direction.

From the standpoints of obtaining good water permeability and resistance to the separation of the chips from the adhesive sheet and/or the admixture of contaminations between the sheet and the chips, ensuring good mechanical strength in the sheet, preventing a decrease in the smoothness of the sheet, and achieving a secure bond between the base film and the adhesive, the base film preferably has a porosity of about 3 to 90%. When the base film contains artificial perforations, the porosity is preferably 3 to 60%, more preferably, 10 to 55%, most preferably 20 to 50%. In this case, the porosity is calculated from the perforation size and the perforation density, i.e.

$$\text{porosity (\%)} = (\text{perforation size}) \times (\text{perforation density}) \times 100.$$

When the base film contains natural perforations of fiber or the like, the porosity is preferably 10 to 80%, more preferably, 20 to 70%. In this case, the porosity is calculated from the weight per unit area of the base film, the material density and the thickness of the base film, i.e.

$$\text{porosity (\%)} = (\text{weight per unit area of the base film}) / (\text{material density}) /$$
$$(\text{thickness of the base film}) \times 100.$$

If necessary, the base film may be subjected to surface treatment such as corona discharge treatment, flame treatment, plasma treatment, sputter etching treatment, undercoating (e.g., primer), fluorine treatment; or degreasing treatment using a chemical solution on the surface thereof on which the adhesive film is formed for the enhancement of the adhesiveness to the adhesive film. Applying a primer is especially preferable. The thickness of the base film is generally 10 to 400 $\mu$m, preferably 30 to 250 $\mu$m, for avoiding fracture or breaking of the sheet during processing the semiconductor wafer or the like as well as decreasing manufacturing cost.

The adhesive sheet of the present invention can be formed by a tape manufacturing method known in this field of technology. For example, the base film possessing perforations and having a cavity ratio of 3.0 to 90% is provided first. It may be provided the perforations after the step of coating the base film with the adhesive. The adhesive, then, can be coated onto the base film material. The base film may be coated directly, or a transfer coating process may be employed in which a process material coated with a release agent is coated with the adhesive and dried, after which the adhesive is laminated to the base film, or the adhesive may be laminated in a rolling mill on the base film. The coating process can be performed by any existing coating method, for example, reverse roll coating, gravure coating, curtain spray coating, die coating, extrusion and other industrially applied coating methods may be used.

The adhesive sheet of the present invention has an adhesive strength of at least 1.5 N/20 mm, preferably at least 3 N/20 mm, and less than 10 N/20 mm, preferably less than 8 N/20 mm or less. In other words, along with changes in dicing technology to technology involving the use of a water jet laser, the critical significance of the adhesive strength of an adhesive sheet used for dicing is also changing, and as a result, good adhesion with the wafer or the like during dicing can be ensure even at a weaker adhesive strength, and chips or parts can be prevented from coming loose from the adhesive tape. In addition, a reduction in the initial adhesive strength allows the adhesive strength of the adhesive after energy irradiation to be effectively, quickly, and easily reduced, and chipping and other such defects to chips, IC parts, and the like during pick-up can be reduced.

Here, an adhesive strength is the value which is measured on an Si-mirror wafer under the conditions of 23 ± 3 °C, 180 ° peeling angle and a peeling speed of 300 mm/min (according to ASTM D1000).

The adhesion strength is generally less than 0.2 N/20 mm, preferably 0.18 N/20 or less mm after the energy irradiation.

The adhesive sheet of the present invention can be used to particular advantage when a workpiece, namely, a semiconductor wafer or the like, is diced into chips of smaller surface area. For example, the size of the individual chips or parts after dicing is preferably less than 9 mm$^2$, 6.25 mm$^2$ or less, 4 mm$^2$ or less, 2.25 mm$^2$ or less, 1 mm$^2$ or less, 0.6 mm$^2$ or less, 0.25 mm$^2$ or less.

The adhesive sheet of the present invention preferably has elongation percentage of over 100%, and more preferably 150%. This is because stretching the adhesive sheet makes it possible for the chips or the like to be easily picked up from the adhesive sheet after the dicing step.

Furthermore, the adhesive sheet preferably has a tensile strength of over 0.1 N/10 mm, more preferably over 0.3 N/10 mm. The reason for this is to avoid breaking and/or cutting the adhesive sheet itself.

The elongation percentage and tensile strength can be measured, for example, with a tensile tester using a sample with a length of S.0 cm and a width of 20 mm. The pulling speed during the test is 300 mm/minute at room temperature (according to ASTM D1000). The elongation percentage can be calculated as follows.

$$\text{Elongation (\%)} = (\text{Fracture Length} - \text{Original Length}) / (\text{Original Length}) \times 100$$

The tensile strength is a value at fracturing.

Examples of the adhesive sheet for water jet laser dicing of the present invention will now be described in detail.

(Preparation of Adhesive)

Example 1

70 weight parts butyl acrylate (Tg of homopolymer =-54°C), 30 weight parts 2-ethylhexyl acrylate (Tg of homopolymer =-85°C), and 10 weight parts of acrylic acid (Tg of homopolymer = 106°C) were copolymerized by a standard method in ethyl acetate to obtain a solution containing an acrylic copolymer with a weight average molecular weight of 1,000,000. To this solution were added 80 weight parts photopolymerizable oligomer (UV1700B, made by Nippon Synthetic Chemical Industry), 8 weight parts photopolymerization initiator (trade name "Irgacure 184," made by Ciba Specialty Chemicals), 10 weight parts melamine resin (trade name "Super Beckamine J-820-60N," made by Dainippon Ink & Chemicals), and 5 weight parts polyisocyanate compound (trade name "Coronate L," made by Nippon Polyurethane Industry), which gave a radiation-curing acrylic adhesive solution.

Example 2

95 weight parts 2-ethylhexyl acrylate (Tg of homopolymer =-85°C), and 5 weight parts of acrylic acid (Tg of homopolymer = 106°C) were copolymerized by a standard method in ethyl acetate to obtain a solution containing an acrylic copolymer with a weight average molecular weight of 700,000. To this solution were added 60 weight parts pentaerythritol triacrylate (1 Pa·sec of viscosity at 25 °C), 3 weight parts photopolymerization initiator (trade name "Irgacure 651," made by Ciba Specialty Chemicals), and 3 weight parts polyisocyanate compound (trade name "Coronate L," made by Nippon Polyurethane Industry), which gave a radiation-curing acrylic adhesive solution.

Example 3

60 weight parts methyl acrylate (Tg of homopolymer = 8°C), 30 weight parts butyl acrylate (Tg of homopolymer =-54°C), and 10 weight parts of acrylic acid (Tg of homopolymer = 106°C) were copolymerized by a standard method in ethyl acetate to obtain a solution containing an acrylic copolymer with a weight average molecular weight of 800,000. To this solution were added 80 weight parts photopolymerizable oligomer (10 Pa- sec of viscosity at 25 °C) which is obtain by reaction of pentaerythritol triacrylate and diisocyanate, 3 weight parts photopolymerization initiator (trade name "Irgacure 651," made by Ciba Specialty Chemicals), 2 weight parts polyisocyanate compound (trade name "Coronate L," made by Nippon Polyurethane Industry), which gave a radiation-curing acrylic adhesive solution.

Example 4

50 weight parts methyl acrylate (Tg of homopolymer =-8°C), 30 weight parts butyl acrylate (Tg of homopolymer = -54°C), and 20 weight parts of acrylic acid (Tg of homopolymer = 106°C) were copolymerized by a standard method in ethyl acetate to obtain a solution containing an acrylic copolymer with a weight average molecular weight of 800,000. To this solution were added 60 weight parts photopolymerizable oligomer (10 Pa·sec of viscosity at 25 °C) which is obtain by reaction of pentaerythritol triacrylate and diisocyanate, 3 weight parts photopolymerization initiator (trade name "Irgacure 651," made by Ciba Specialty Chemicals), 2 weight parts polyisocyanate compound (trade name "Coronate L," made by Nippon Polyurethane Industry), which gave a radiation-curing acrylic adhesive solution.

Comparative Example 1

100 weight parts acrylic resin Leocoat 1020 (made by First lace Co. Ltd.), 30 weight parts dioctyl phthalate, and 10 weight parts of melamine resin (trade name "Super bekamine" made by Nippon Polyurethane Industry) were copolymerized by a standard method in toluene to obtain a pressure-sensitive acrylic adhesive solution.

Comparative Example 2

100 weight parts acrylic resin Leocoat 1020 (made by First lace Co. Ltd.), 20 weight parts dioctylphthalate, and 8 weight parts of melamine resin (trade name "Super bekamine" made by Nippon Polyurethane Industry) were copolymerized by a standard method in toluene to obtain a pressure-sensitive acrylic adhesive solution.

(Base Film)

A non-woven sheet was used which had perforations of 0.1 to 0.3 mm in size, had a thickness of 200 $\mu$m, was composed of polypropylene fiber, and had a porosity of 30%.

(Production of Adhesive Sheet for Dicing)

The adhesive solutions prepared above were used to coat a polypropylene non-woven sheets, respectively, and the coating was heated and crosslinked for 10 minutes at 80°C to form an adhesive layer with a thickness of 10 $\mu$m. Next, a separator was applied to the adhesive layer side to produce UV-curing or pressure sensitive type of dicing adhesive sheets.

(Peel Strength with Silicon Wafer)

The dicing adhesive sheets obtained above Examples and Comparative Examples were cut into a strip 25 mm wide, and were applied to silicon mirror wafers (made by Shin-Etsu Semiconductor; CZN <100> 2.5 to 3.5 (4-inch)) at 23°C (room temperature), respectively. These were left for 30 minutes under a nitrogen atmosphere, and the 180° peel strength (pulling rate of 300 mm/minute) was measured at a constant room temperature of 23°C. The peel strength was also measured after applying the sheet to the silicon mirror wafers and then irradiating it with UV rays at an intensity of 500 mJ/cm$^2$.

(Dicing conditions)

Die fly-off rate (chip fly rate, %) is calculated at dicing semiconductor chips in the following conditions.

Laser wavelength: 532 nm

Dicing speed: 50 mm/s
Laser diameter: 50 μm
Water jet pressure: 8 MPa
Chip size: 0.3 mm × 0.3 mm, 1 mm × 1 mm, 2.5 mm × 2.5 mm, 5 mm × 5 mm,
Wafer size: 13.7 cm (5 inch)
Wafer thickness: 100 μm.

(Pick-up Conditions)

The diced semiconductor chips were irradiated with UV rays from the back side of the sheet (20 seconds of irradiation at an intensity of 500 mJ/cm$^2$). Any 50 semiconductor chips were picked up (separated) under the following conditions, the number of chips successfully picked up was counted, and the pick-up success rate (%) was calculated.
Conditions of Equipment
Diebonder: NEC machinery CPS-100
Pin number: 4
Pin interval: 3.5×3.5 mm
Curvature of pin tip: 0.250 mm
Pin poke-up length: 0.50 mm
Adsorption holding time: 0.2 sec.
Expanded length: 3 mm.
The results are shown in Table 1.

Table 1

Upper: Die fly-off rate (%)

Lower: Success rate of pick-up (%)

| | Adhesive Strength for Si | | Chip Size | | | |
|---|---|---|---|---|---|---|
| | Before UV-curing (N/20mm) | After UV-curing (N/20mm) | 0.3 (mm) | 1.0 (mm) | 2.5 (mm) | 5.0 (mm) |
| Ex.1 | 1.6 | 0.12 | 0.9 | 0.0 | 0 | 0 |
| | | | 100 | 100 | 100 | 100 |
| Ex.2 | 3 | 0.15 | 0 | 0 | 0 | 0 |
| | | | 100 | 100 | 100 | 100 |
| Ex.3 | 6 | 0.18 | 0 | 0 | 0 | 0 |
| | | | 100 | 100 | 100 | 100 |
| Ex.4 | 12 | 0.14 | 0 | 0 | 0 | 0 |
| | | | 100 | 100 | 100 | 100 |
| Comparative Ex.1 | 0.5 | ← | 25 | 17 | 11 | 9 |
| | | | 85 | 81 | 68 | 53 |
| Comparative Ex 2 | 1.8 | ← | 1.1 | 0.66 | 0 | 0 |
| | | | 47 | 41 | 29 | 20 |

As Comparative Examples 3 to 6, adhesive sheets were produced in the same manner as in Examples 1 to 4, except that base films with no perforations were used. Dicing was performed under the same conditions as above, and in every case there was no place for the water jet to escape, the water overflowed the wafer surface, and water penetrated in between the wafer and the sheet, which either caused the chips to rebound, or prevented the wafer from being diced into chips.

As is clear from Table 1, in Examples in which the adhesive strength of the adhesive sheet was at least 1.5 N/20 mm and a radiation curing type of adhesive was used, there was substantially no die fly-off, and good results were obtained for the pick-up success rate. Furthermore, even when the water jet pressure was quite high, the water could easily pass through, and no deterioration was noted in the adhesive strength during dicing.

On the other hand, die fly-off tended to occur when the adhesive strength was too weak, and when the adhesive strength during pick-up was extremely weak, the chips were seen to be prone to chipping, cracking, and so on.

This application claims priority to Japanese Patent Application No. 2006-232733. The entire disclosure of Japanese Patent Application No. 2006-232733 is hereby incorporated herein by reference.

While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims and their equivalents. Thus, the scope of the invention is not limited to the disclosed embodiments.

## Claims

1. An adhesive sheet for water jet laser dicing, comprising an adhesive layer laminated on a base film, wherein the adhesive constituting the adhesive layer is an energy radiation curing type adhesive, and said adhesive sheet has an adhesive strength of at least 1.5 N/20 mm.

2. The adhesive sheet according to Claim 1, wherein the adhesive sheet has perforations, and has a porosity of 3 to 90%..

3. The adhesive sheet according to Claim 1, wherein the base film includes a layer composed of polyolefin.

4. The adhesive sheet according to Claim 1, wherein the perforations have a diameter of 5 to 800 $\mu$m.

5. The adhesive sheet according to Claim 1, wherein the perforations are from 25 $\mu$m$^2$ to 3.0 mm$^2$ in size.

6. The adhesive sheet according to Claim 1, wherein the adhesive is a rubber-based or acrylic-based adhesive.

7. The adhesive sheet according to Claim 1, wherein the adhesive sheet has an elongation of over 100%.

8. The adhesive sheet according to Claim 1, wherein the adhesive sheet has a tensile strength of over 0.1 N/10 mm.

9. The adhesive sheet according to Claim 1, wherein the adhesive strength after energy irradiation is less than 0.2 N/20 mm.

**EP 1 894 662 A2**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9532834 A
- JP 2001316648 A

- JP 2006232733 A